Europäisches Patentamt

European Patent Office

Office européen des brevets

(19)

(11) Veröffentlichungsnummer: **0 053 812**
**A2**

(12) # EUROPÄISCHE PATENTANMELDUNG

(21) Anmeldenummer: 81110125.2

(22) Anmeldetag: 03.12.81

(51) Int. Cl.³: **H 01 L 25/14**

(30) Priorität: 05.12.80 JP 171738/80

(43) Veröffentlichungstag der Anmeldung:
16.06.82 Patentblatt 82/24

(84) Benannte Vertragsstaaten:
AT BE DE FR GB NL SE

(71) Anmelder: FUJI ELECTRIC CO. LTD.
1-1, Tanabeshinden, Kawasaki-ku
Kawasaki 210(JP)

(72) Erfinder: Baba, Kenji
No. 11-8, Tamadaira 3-chome
Hino-shi Tokyo(JP)

(74) Vertreter: Mehl, Ernst, Dipl.-Ing. et al,
Postfach 22 01 76
D-8000 München 22(DE)

(54) Thyristorsäule.

(57) Die Erfindung betrifft eine Thyristorsäule mit Scheibenthyristoren (3) und Kühlkörpern (2), die alternierend nebeneinandergestapelt und in einer rahmenartigen Einspannvorrichtung (1) unter vorgegebenem Druck elastisch gehalten
sind. Die Einspannvorrichtung (1) besteht aus zwei endseitigen Widerlagern (1a, 4), die über Spannbolzen (8) miteinander verbunden sind, wobei jeder Spannbolzen (8) mit einer
Isolationshülse (5) umgeben ist, die auch durch Bohrungen
(2a) der Kühlkörper (2) verläuft. Zur Vermeidung von Koronaentladungen ist die gesamte Innenfläche jeder Isolationshülse (5) mit einer Schicht (7) aus leitfähigem Material
versehen, die über einen leitfähigen Kleber (9) mit dem
zugehörigen Spannbolzen (8) fest verbunden ist. Auf der
Außenfläche jeder Isolationshülse (5) ist in jedem Bereich, in
dem sie durch eine Bohrung (2a) eines Kühlkörpers (2)
verläuft, eine weitere Schicht (10) aus leitfähigem Material
angeordnet, die mit dem zugehörigen Kühlkörper (2) elektrisch leitend verbunden ist. Mit dieser Ausgestaltung entsteht ein elektrisches Feld gleichförmig nur in der Isolationsröhre (5) und elektrische Entladungen sind vermieden.

FIG 2

EP 0 053 812 A2

0053812

FUJI ELECTRIC Co., Ltd.      Mein Zeichen
Kawasaki / Japan            VPA 80 P 8 5 9 8 E

## Thyristorsäule

(Es wird die Priorität aus der japanischen Anmeldung T 55-171 738 vom 05.12.1980)

Die Erfindung betrifft eine Thyristorsäule mit Scheibenthyristoren und Kühlkörpern, die alternierend nebeneinandergestapelt und in einer rahmenartigen Einspannvorrichtung unter Druck elastisch gehalten sind, wobei die Einspannvorrichtung aus zwei endseitigen Widerlagern besteht, die über Spannbolzen miteinander verbunden sind und wobei jeder Spannbolzen mit einer Isolationshülse umgeben ist, die auch durch Bohrungen der Kühlkörper verläuft.

Eine solche Thyristorsäule mit luftgekühlten Kühlkörpern ist aus der Siemens-Zeitschrift 45 (1971), Seiten 292 bis 294 und aus der Siemens-Zeitschrift 48 (1974), Seiten 791 bis 798 bekannt.

Bei dieser Thyristorsäule ist im Betriebszustand das Potential jedes Kühlkörpers größer als das einheitliche Potential der leitfähigen Teile der Einspannvorrichtung, wobei insbesondere bei Hochspannungsanwendungen, beispielsweise in der HGÜ-Technik sehr große Potentialunterschiede auftreten können.

Bei diesem Aufbau sind wegen der Potentialdifferenzen zwischen den Spannbolzen der Einspannvorrichtung und den Kühlkörpern in den Bereichen, in denen die Spannbolzen die Kühlkörper durchdringen, Spannungen eingeprägt. Die größte eingeprägte Spannung tritt im Durchdringungsbereich wenigstens eines der endseitigen

Soe 2 Bim / 30.11.1981

Kühlkörper auf, wo zwischen Kühlkörper und zugehörigem
Widerlager ein zusätzlicher Isolator eingefügt ist.
Wegen der eingeprägten Spannungen ist eine weitere
Isolation erforderlich.

Bei der bekannten Thyristorsäule wird die weitere
Isolation durch die Isolationshülsen bewirkt, die über
die Spannbolzen geschoben sind. Dabei sind ungeachtet
einer genügend großen Isolierfähigkeit der Isolationshülsen Luftstrecken in Querrichtung der Spannbolzen
unvermeidbar, die außerdem wegen der unvermeidlichen
Toleranzen noch unterschiedlich groß sein können. Die
eingeprägten Spannungen liegen daher in Querrichtung
zumindest an einzelnen Stellen an verhältnismäßig kurzen Luftstrecken, so daß dort hohe elektrische Feldstärken auftreten können. Zum Beispiel geringe Ungleichmäßigkeiten der Bolzenoberfläche oder der Innenfläche
der Isolationshülse können erhöhte Feldkonzentrationen
zur Folge haben, die von Sprüh- oder Glimmerscheinungen
bis zu Teilentladungen führen können, die die Isolationsfähigkeit herabsetzen. Eine Vergrößerung der Luftstrecken in Querrichtung, mit der Entladungserscheinungen vermieden und eine ausreichende Isolation auch
bei Hochspannungsanwendungen sichergestellt werden
könnte, würde zu einer wesentlichen räumlichen Vergrößerung der Thyristorsäule führen.

Der Erfindung liegt die Aufgabe zugrunde, die Isolierung bei einer eingangs genannten Thyristorsäule so
auszugestalten, daß ohne Vergrößerung des Raumbedarfs
eine ausreichende Isolation auch bei Betrieb mit Hochspannung sichergestellt ist.

Erfindungsgemäß wird diese Aufgabe dadurch gelöst, daß
die gesamte Innenfläche jeder Isolationshülse mit einer
Schicht aus leitfähigem Material versehen ist und daß die Außenfläche jeder Isolationshülse in jedem Bereich in dem sie durch eine Bohrung eines Kühlkörpers verläuft, mit einer weiteren Schicht aus leitfähigem Material bedeckt ist.

Vorzugsweise ist der Widerstandswert der leitfähigen Schicht, die auf der Innenfläche jeder Isolationshülse aufgebracht ist, kleiner als der Widerstandswert der leitfähigen Schicht, die auf der Außenfläche der Isolationshülse vorgesehen ist.

Bei der erfindungsgemäßen Thyristorsäule liegt ein elektrisches Feld gleichmäßig nur an der Isolationsröhre an. Diese Thyristorsäule ist daher für eine hohe Druckhaltung geeignet. Koronaentladungen sind unterbunden und ohne Vergrößerung des Raumbedarfs ist eine Verringerung der Isolationsfähigkeit vermieden, wobei es günstig ist, die Schichten auf den Außenflächen der Isolationsröhren mittels Kontaktfedern mit den zugeordneten Kühlkörpern elektrisch leitend zu verbinden.

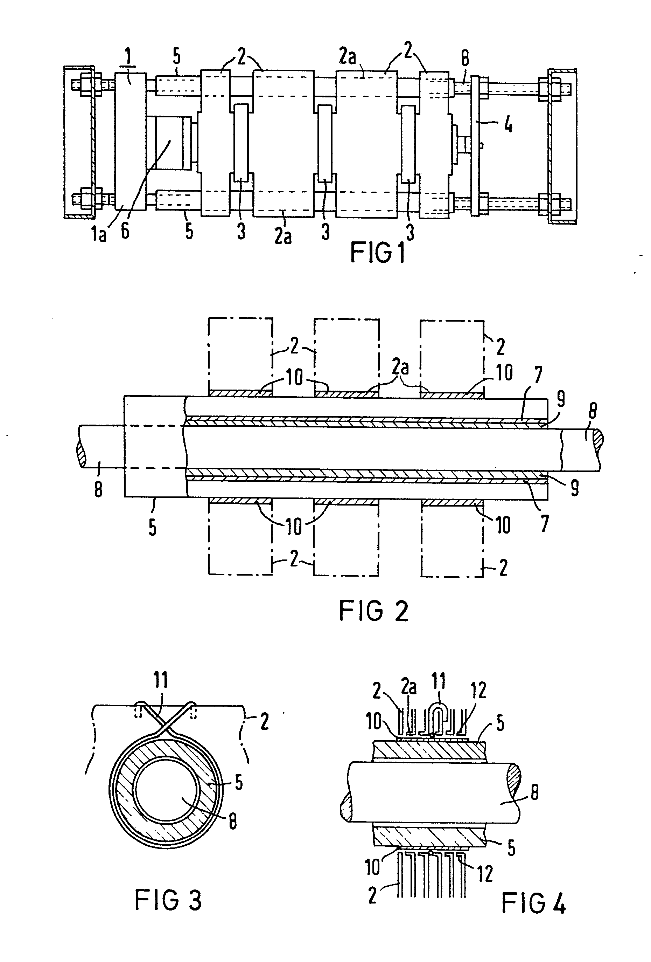

Im folgenden wird die erfindungsgemäße Thyristorsäule beispielhaft anhand der Figuren 1 bis 4 näher erläutert.

Die in Figur 1 in Draufsicht gezeigte Thyristorsäule enthält Scheibenthyristoren 3, wobei an jeder Seite eines Scheibenthyristors 3 ein flacher Kühlkörper 2 anliegt. Die Kühlkörper 2 können flüssigkeits- oder luftgekühlt sein.

Die Scheibenthyristoren 3 sind zusammen mit den Kühlkörpern 2 in eine rahmenartige Einspannvorrichtung 1 eingespannt, die im wesentlichen von zwei als Widerlager dienenden Spannplatten 4 und 1a und von Spannbolzen 8 gebildet wird, die durch Bohrungen 2a der Kühlkörper 2 verlaufen. Im Ausführungsbeispiel ist die Spannplatte 4 eine Blattfeder. Die Spannplatte 4 ist damit als Druckelement ausgebildet, mit dem die Scheibenthyristoren 3 zusammen mit den Kühlkörpern 2 mit einem vorgegebenen Druck eingespannt sind.

Zur Isolation ist endseitig zwischen dem letzten Kühlkörper 2 und der Spannplatte 1a ein Isolierkörper 6 vorgesehen und die Spannbolzen 8 sind zumindest im Bereich der Bohrungen 2a der Kühlkörper 2 jeweils von einer durchgehenden Isolationshülse 5 umgeben.

Die erfindungsgemäße Ausgestaltung, mit der eine Verminderung der Isolationsfähigkeit aus den oben dargelegten Gründen auch bei Betrieb unter Hochspannung vermieden wird, zeigt beispielhaft Figur 2. In Figur 2 ist teilweise im Schnitt eine vergrößerte Ansicht eines Bolzens 8 der Einspannvorrichtung 1 der Figur 1 dargestellt, wobei Kühlkörper 2 gestrichelt angedeutet sind.

Die gesamte Innenfläche der durchgehenden Bohrung der Isolationshülse 5 ist mit einer Schicht 7 aus leitfähigem Material versehen. Die Schicht 7 kann als Anstrich aufgebracht sein. Zwischen der leitfähigen Schicht 7 und dem Spannbolzen 8 ist durchgehend ein vorzugsweise gut leitfähiger Klebstoff 9 vorgesehen, der die Isolationshülse 5 und den Spannbolzen 8 fest miteinander verbindet.

Leitfähige Außenschichten 10 sind auf Teilen der Außenfläche der Isolationshülse 5 in den Bereichen angeordnet, in denen diese in Bohrungen 2a von Kühlkörpern 2 verlaufen. Die leitfähigen Außenschichten 10 können an den Bohrungskanten der Kühlkörper 2 oder, wie gezeigt, durchgehend im ganzen Bereich jeder Bohrung 2a vorgesehen sein. Die Schicht 10 kann wieder als Anstrich aufgebracht sein, wobei ein kohlenstoffhaltiges Material verwendet werden kann. Vorzugsweise besitzt die leitfähige Schicht 7a auf der Innenseite der Isolationshülse 5 einen relativ niedrigen und die leitfähigen
Schichten 10 auf der Außenfläche einen relativ hohen
Widerstandswert.

Falls zwischen einem Kühlkörper 2 und der zugehörigen
leitfähigen Oberflächenschicht 10 auf der Oberfläche
der Isolationshülse 5 ein Luftspalt auftritt, muß ein
elektrischer Kontakt zwischen den Kühlkörper 2 und der
zugehörigen Oberflächenschicht 10 sichergestellt sein,
um eine Teilentladung in diesem Bereich zu verhindern.
Anhand der Figuren 3 und 4 wird beschrieben, wie ein
solcher Kontakt beispielsweise bei einem luftgekühlten
Kühlkörper 2 mit Kühlfinnen 12 erhalten werden kann.
Dabei zeigt Figur 3 einen  Querschnitt durch einen
Spannbolzen 8 im Bereich eines Kühlkörpers 2 und
Figur 4 einen Längsschnitt ebenfalls im Bereich eines
Kühlkörpers 2.

In der Bohrung 2a des Kühlkörpers 2 sind die Kühlfinnen 12 abgekantet und eine gebogene Kontaktfeder 11
ist an einer der Kühlfinnen 12 festgeklemmt. Die Kontaktfeder 11 besitzt eine Leitfähigkeit etwa wie
Phosphorbronze. Nach dem Zusammenbau ist die Kontaktfeder 11 eingeklemmt und gegen die Oberfläche der
Schicht 10 gedrückt. Damit wird die Schicht 10 in
elektrischen Kontakt mit dem Kühlkörper vermittels der
Druckkraft der Kontaktfeder 11 gebracht. Die leitfähige Schicht 10 und der Kühlkörper 2 bleiben so in
sicherem, elektrischem Kontakt miteinander und jede
leitfähige Schicht 10 und der zugehörige Kühlkörper 2
befinden sich auf gleichem Potential.


4 Figuren
4 Patentansprüche

Patentansprüche

1. Thyristorsäule mit Scheibenthyristoren und Kühlkörpern, die alternierend nebeneinandergestapelt und in einer rahmenartigen Einspannvorrichtung unter Druck elastisch gehalten sind, wobei die Einspannvorrichtung aus zwei endseitigen Widerlagern besteht, die über Spannbolzen miteinander verbunden sind und wobei jeder Spannbolzen mit einer Isolationshülse umgeben ist, die auch durch Bohrungen der Kühlkörper verläuft, d a - d u r c h  g e k e n n z e i c h n e t , daß die gesamte Innenfläche jeder Isolationshülse (5) mit einer Schicht (7) aus leitfähigem Material versehen ist und daß die Außenfläche jeder Isolationshülse (5) in jedem Bereich, in dem sie durch eine Bohrung (2a) eines Kühlkörpers (2) verläuft, mit einer weiteren Schicht (10) aus leitfähigem Material bedeckt ist.

2. Thyristorsäule nach Anspruch 1, d a d u r c h g e k e n n z e i c h n e t , daß der Widerstandswert der leitfähigen Schicht (7) die auf der Innenfläche jeder Isolationshülse (5) aufgebracht ist, kleiner als der Widerstandswert der leitfähigen Schichten (10) ist, die auf der Außenfläche der Isolationshülse (5) vorgesehen sind.

3. Thyristorsäule nach Anspruch 1 oder 2, d a - d u r c h  g e k e n n z e i c h n e t , daß jede leitfähige Schicht (10) auf der Außenfläche einer Isolationshülse (5) mit dem zugehörigen Kühlkörper (2) über eine Kontaktfeder (11) elektrisch leitend verbunden ist.

4. Thyristorsäule nach Anspruch 3, d a d u r c h g e k e n n z e i c h n e t , daß jede Kontaktfeder (11) aus einer Phosphorbronze hergestellt ist.

0053812

1/1          80 P 8598   E

FIG 1

FIG 2

FIG 3          FIG 4